# EUROPEAN PATENT APPLICATION

(11) **EP 2 019 249 A1**
(43) Date of publication of application: **28.01.2009**
(21) Application number: 07113036.3
(22) Date of filing: 24.07.2007
(51) Int. Cl.: F21K 7/00, H01L 33/00

(54) **Device for the regularization of a high intensity light beam**

(71) Applicant: Dall'Oglio, Stefano, 20146 Milano (IT); Dall'Oglio, Giorgio, 20146 Milano (IT)
(72) Inventor: Dall'Oglio, Stefano, 20146 Milano (IT); Dall'Oglio, Giorgio, 20146 Milano (IT)
(74) Representative: Gervasi, Gemma

(57) **Abstract**

Device for the regularization of a high intensity light beam for measurement instrumentation, employing light sources characterized by spatial irregularities in the distribution of the emitted energy such as high power mosaic LED emitters having one or more wavelengths or chemiluminescence o fluorescence emission sources, adapted to improve the intensity regularisation of the beam and to reduce the radiation emission angle with maximum energetic efficiency.

## Description

### FIELD OF INVENTION

The present invention concerns the non-image optics field in particular concerning the regularisation of the intensity of the light beams emitted by a plurality of light sources including sources having multiple wavelengths and characterised by radiation distribution discontinuities. Examples of sources of this kind may comprise, for example, high power LEDs comprising: photo-emitters mosaics, groups of single LEDs suitably grouped in order to increase their light power or to obtain different colours light beams through mixing of different colour light beams; chemiluminescence o fluorescence emission sources radiating from free surfaces or from optically transparent containers.

The evenness of the spatial distribution of the light beam intensity is an essential requirement for the employment of refraction optic systems for beam focalization like, for example, focalization optic systems comprising lenses.

The focalized beam intensity transversal distribution is correlated to uniformity degree of the source intensity distribution and to the angular divergence of the beam entering the first lens of the focalization optic system and in case of employment of different wavelengths light sources, additionally requires the employment of achromatic type lens systems.

In case the light source is implemented through the employment of a high intensity LED type source the possibility of focalizing the light beam down to a dimension of a few tens of micrometers, requires both the regularization of the beam emitted by the mosaic high power LEDs source and the reduction of the divergence angle before entering the lens focalization optic system.

In case the light source is of chemiluminescence or chemical fluorescence emission type, we are in presence of a plurality of sources distributed over an emission surface approximable to a very high number of elementary sources casually active both in time and in space and thus very difficult to concentrate with refraction optic systems.

In case the light source is implemented through the employment of several high intensity LED sources, the possibility of regularizing the light beam chromatic distribution requires both the high power mosaic LED source emitted beams mixing and the reduction of the divergence angle before entering the lens focalization optic system.

In particular the invention refers to an optic systems constituted by a reflection element for the regularization of the light beam that is adapted to optimize the energetic efficiency of the management of the light beam produced by the source and to dramatically reduce the dispersion angle of the output light beam; moreover being the present invention based on the reflection phenomenon it is intrinsically achromatic and is independent from the wavelength of the light beam radiation and it is, thus, employable for sources of any wavelength without the need of adaptation or regulation.

### STATE OF THE ART

The usual methods for the regularization of the light beams generated by non-uniform sources employ various types of diffusers (see for example those described in catalogue n. 28a issued into 2002 by Edmund Industrial Optics, page 64 and 65). Said systems are based on the mixing technique, implemented by the employment of a light beam diffuser element, which allows to obtain intensity distribution regulation but they are characterised by the disadvantages of increasing the light beam divergence and allowing for an important energy loss caused by the diffuser element energy absorption.

The remarkable divergence of the light beam makes the design of the condenser element placed at the input of the focalization of optic system difficult since it requires the employment of high price aspheric lenses together with diaphragm spatial filters causing further light energy losses.

### SCOPE OF THE INVENTION

Scope of the present invention is to disclose a new and more efficient solution to the problem of the regularization of the light beam produced by a multiple source characterized by non-uniform emissivity or by a plurality of sources having different wavelengths, with an optimized energy efficiency and with an output light beam dispersion angle reduced with respect to the one of the input light beam.

### SUMMARY OF THE INVENTION

The above scope of the invention has been fulfilled by a system according to the present invention characterised by the employment of an element constituted by one or more superimposed cone or pyramid frusta having circular, elliptic or polygonal section, of tubular type or made of solid, optically transparent material.

Said element is characterized by the presence of conic, curved or pyramidal surfaces having high reflectivity towards the inside of said element and, in case it is made of solid, optically transparent material, characterized by light transparent surfaces on the light beam input and output side.

Said component is well known in the field of reflection optics, because it is able to modify the divergence of the light beam running through it: the theory referring to a punctiform light beam is described and illustrated in the book: "Handbook of Optics" published by McGraw - Hill Book Co. (ISBN 0-07-047710-8) on pages 2-55 and 2-56 - Section 2 - paragraph 44 - Light Pipes.

In the preferred embodiment of the invention the light beam produced by the non-punctiform source is supposed to enter the conic or pyramidal element through the smaller opening and the output light beam emitted through the larger opening would be characterized by a reduced divergence with respect to the one of the input beam.

Said phenomenon is easily explainable by noting that the input beams having divergence lesser than or equal to the element lateral surface aperture angle run through it without deviations, while those emitted on larger angles go through one or more total reflections on the specular surface and are deviated towards the centre of the light beam.

Moreover, the phenomenon of the reflection of the light beams emitted by several sources placed in different positions with respect to the axis of the element object of the present invention and with angles greater than the divergence angle of the reflecting surface, implies significant mixing of the reflected beams thus achieving the effect of regularization of the output optical beam energy distribution.

The invention can be implemented in a preferred embodiment by manufacturing a cone or pyramid frustum of tubular type, with circular or elliptic or polygonal section respectively, by pressing or forming or by fusion or melting or by mechanical treatment of a solid material such as plastic or metal, in order to make a conic cavity adapted to be processed through know techniques for polishing or metallization or by a reflecting thin layer placed on its internal side in such a way to obtain a reflecting conic cavity.

The invention can be implemented in another preferred embodiment by a cone or pyramid frustum of tubular type, with circular or elliptic or polygonal section respectively by pressing or forming or by fusion or melting or by mechanical treatment of a solid material such as plastic or metal, in order to make two separate shells each of them comprising a semi-conic cavity adapted to be processed through know techniques for polishing or metallization or by a reflecting thin layer deposition, said cavities been placed in such a position to realized a reflecting conic cavity after juxtaposition of said shells.

The invention can be implemented in another preferred embodiment by a cone or pyramid frustum of solid material having circular or elliptic or polygonal section respectively by mechanical treatment of an optically transparent solid material like, for instance, optical glass or quartz or plastic in order to produce a frusto-conical or frusto-pyramidal element having polishable external surfaces: in this case said surfaces are not metallized since the light rays entering through the minor flat surface of the element and characterized by a lower divergence of the total reflection angle are totally reflected on the inclined surfaces due to the total reflection phenomenon described and illustrated in the: "Handbook of Optics published by Mcgraw-Hill Book Co. pages 13-6 to 13-9 - section 13 - paragraph 10 - total internal reflection.

The invention can be furthermore completed by a section of focalization carried out by a combination of one of the above described reflection typologies having one or both surfaces of luminous flux input and output made through manufacturing of a concave, plane or convex shape having geometric spheric or aspheric characteristic or through gluing of optical lenses in order to produce optically active surfaces.

As far as the reflecting surfaces are concerned, it's necessary to remind that the reflecting treatment does not have to be applied to every potentially reflecting surface, but it can be applied in a selective way only to some of them or to suitably selected parts based on the analysis of the rays produced by their reflections.

### BRIEF DESCRIPTION OF THE DRAWINGS

Fig. 1 a displays the transversal section of the frusto-conical element, of tubular kind and circular section, representing a first preferred embodiment of the device according to the present invention.
Fig. 1b displays the top view of the frusto-conical element, of tubular kind and circular section, representing a first preferred embodiment of the device according to the present invention.
Fig. 2a displays the transversal section of the frusto-conical element, of tubular kind and circular section, representing a second preferred embodiment of the device according to the present invention.
Fig. 2b displays the top view of the frusto-conical element, of tubular kind and circular section, representing a second preferred embodiment of the device according to the present invention.
Fig. 3 displays the frusto-conical element, of tubular kind and circular section, of the device according to the present invention with the addition of a condenser made by a bi - convex lens inserted at the luminous flux output.
Fig. 4 displays the frusto-conical element, having circular section, of the device according to the present invention, made of optically transparent solid material having both input and output surfaces non - plane and manufactured in order to have a luminous flux input concave lens and a luminous flux output convex lens.
Fig. 5 displays the transversal image of the beam emitted by the high intensity LED source produced by Opto Diode Corp., Newbury Park, Calif. - USA and described on pages 75 and 76 of the 1996 catalogue. [X and Y axis = 4mm/div. - Z axis relative intensity with full scale = 100%]
Fig. 5b displays the transversal image of the beam emitted by the high intensity LED after going through a conic reflecting element according to the present invention [X and Y axis = 4mm/div. - Z axis relative intensity with full scale = 100%]

### DETAILED DESCRIPTION OF THE INVENTION

As an illustrative example, non limiting of the scope of the present invention, we consider the technical problem of regularizing the light beam produced by a high intensity source of the aculed type as, for example, the source produced by Perkin Elmer Elkos^{™} Gmbh, as described in the datasheet 600034_02 dts1105p.

Said source is constituted by 4 LED sources, one of them generating a blue colour light beam having average wavelength of 470 nanometers, two of them generating 2 green colour light beams of average wavelength of 535 nanometers and one of them generating a red colour light beam of average wavelength of 635 nanometers, with an output beam of typical total power of 12 mW, comprised for about 60% inside a cone having semi-angle of 40 degrees as described in the cited technical papers.

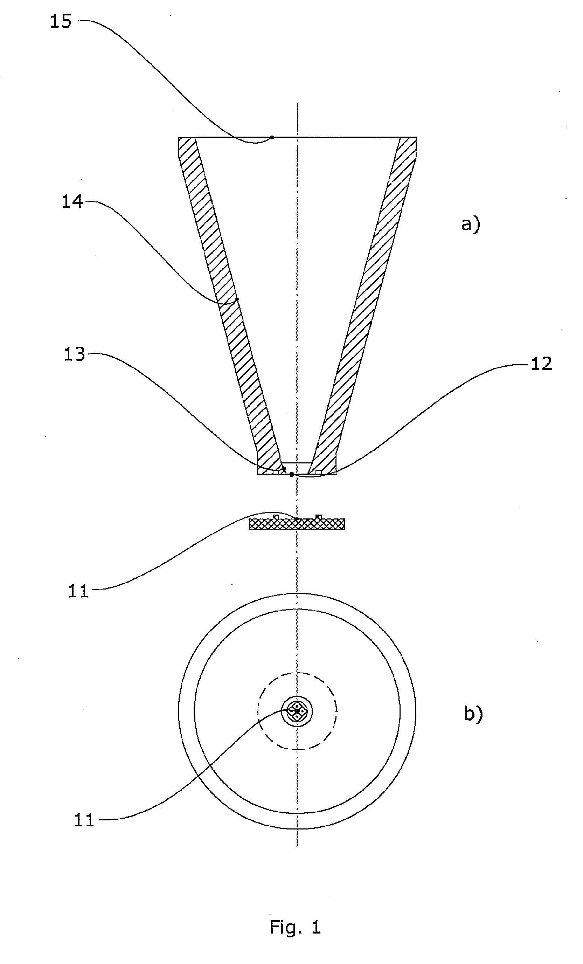

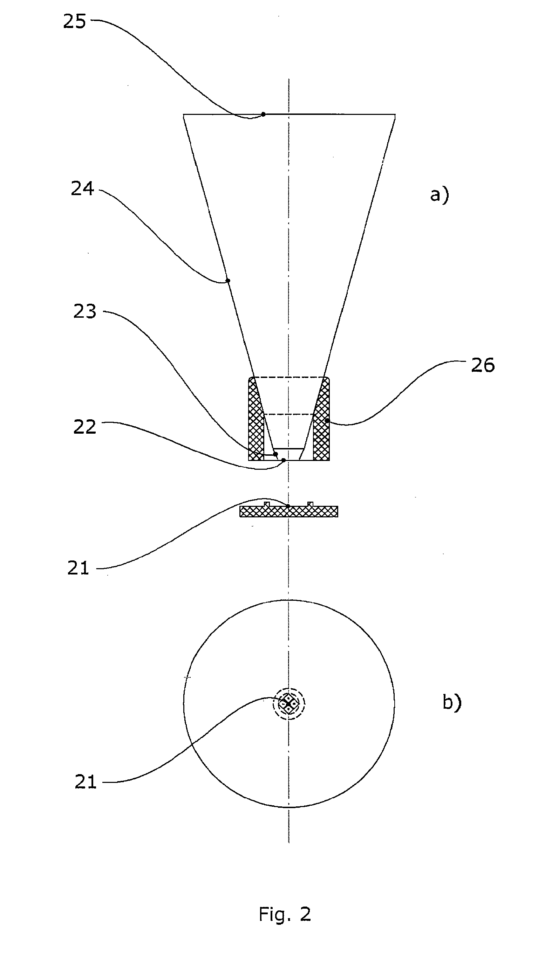

The two preferred embodiments of the present invention are the following: the first employs a hollow element characterized by a main axis of symmetry and by an internal surface of variable dimension having circular or elliptic or polygonal section, provided with a reflecting metallization on the internal surface of the tube as shown in figures 1 a and 1b; the second employs a solid element made of optically transparent material characterized by a main axis of symmetry and by an external surface of variable dimension having circular or elliptic or polygonal section, provided with a reflecting metallization on the external surface but with no metallization on the two surfaces crossed by the axis of symmetry, as illustrated in figures 2a and 2b.

Figures 1 a and 1 b represent a first preferred embodiment of the present invention and in particular the frusto-conical element, with circular section, of tubular type, manufactured according to any of the preferred embodiments already described, consisting of the sequence of two conical surfaces with different aperture angles with respect to the symmetry axis, being said internal surface metallized.

Fig. 1 a displays the transversal section of said frusto-conical element while Fig. 1 b displays the corresponding top view. The details highlighted are the following:
- the light source LED 11;
- the light input surface 12;
- the light reflection surface of the first conical element 13;
- the light reflection surface of the second conical element 14;
- the light output surface 15;

Fig. 2a and 2b display a second preferred embodiment of the present invention and in particular the solid element made of optically transparent material characterized by a principal symmetry axis and by an external surface whose diameter varies depending on the length, having circular, elliptical or polygonal section, characterized by a reflecting metallization on the external surface, but without metallization on the two surfaces crossed by the symmetry axis which are aimed to input and output the light beam.

Fig. 2a displays the transversal section of said frusto-conical element while Fig. 2b displays the corresponding top view. The highlighted details are the following:
- the light source LED 21;
- the light input surface 22;
- the light reflection surface of the first pyramidal element 23;
- the light reflection surface of the second pyramidal element 24;
- the light output surface 25;
- the supporting tubular element of the optically active element 26;

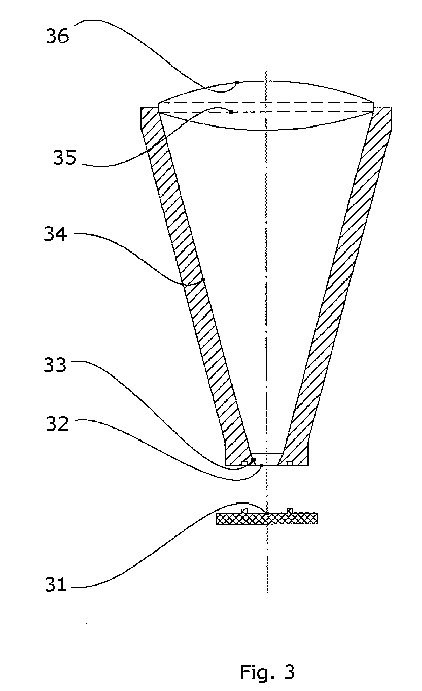

Fig. 3 displays the frusto-conical element of tubular type, having circular section, referring to the first preferred embodiment of the present invention, further provided with a condenser made with a bi-convex lens inserted at the luminous flux output.

With reference to Fig. 3, the following details can be seen:
- the light source LED 31;
- the light input surface 32;
- the light reflection surface 33, 34;
- the light output surface 36;
- the output condenser 35;

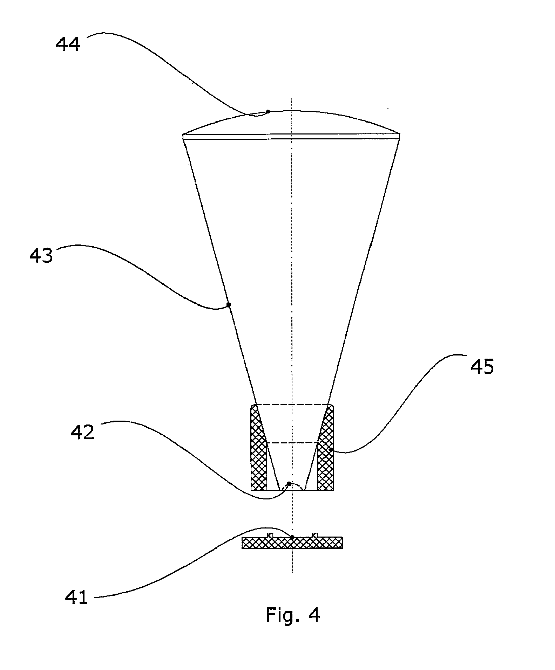

Fig. 4 displays an additional preferred embodiment of the present invention comprising the frusto-conical element having circular section -preferably made of an optically transparent solid material and comprising a non plane output surface - having both input and output surfaces non plane but manufactured in a way to make an input concave lens and an output convex lens.

With reference to Fig. 4, the following details can be seen:
- the light source LED 41;
- the light input convex surface 42;
- the light reflecting surface 43;
- the light output concave surface 44;

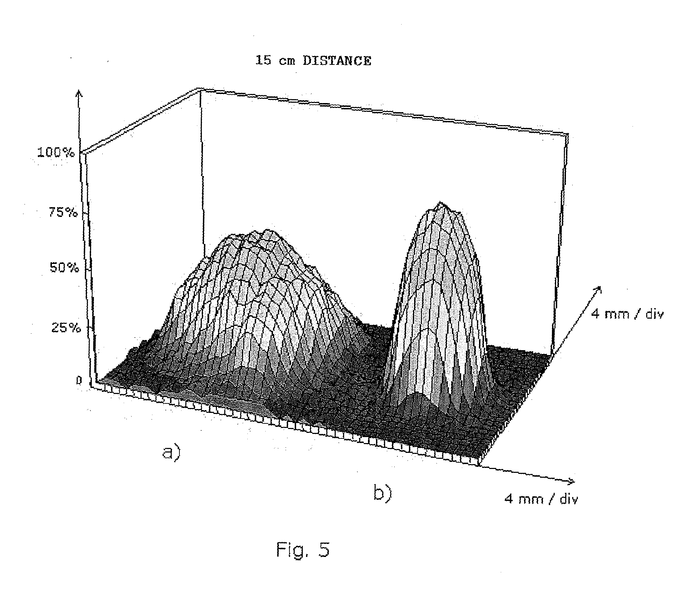

The enclosed Fig. 5a refers to the transversal image of the beam emitted by the high intensity LED source model High Output Blue LED OD470 manufactured by Opto Diode Corp. Newbury Park, Calif. U.S.A. and described on pages 75 and 76 of the 1996 catalogue.

Such source generates a blue color, having average wavelength of 470 nanometers, with typical total power of 12 mW, comprised for about 80% inside a cone having semi-angle of 20 degrees as described in the cited technical papers.

As a matter of fact, said source is made of a mosaic of 16 elementary emitters, and the focalized image of the light beam allows spotting the inevitable differences of intensity of the zones in which the elementary light beams are juxtaposed.

Said image has been collected on a screen placed 15 centimeter away from the base of the source: the beams emitted by the LED emitters single elements can be spotted in the image as higher intensity areas.

The enclosed Fig. 5b represents the transversal image of the light beam emitted by the LED source which has crossed a reflecting conical element of the kind depicted in the Fig. 1a, collected as in the case depicted in Fig. 5a on the same screen placed 15 centimeters away from the base of the source: the image of the light beam is characterized by a smaller diameter, by the increase of the maximum intensity, and the effects of the single emitting elements are no longer visible.

In a further embodiment - depicted for the sake of simplicity only with reference to Fig. 1 but applicable to all the cases described from Fig. 1 to Fig. 5b - in case of biochemical measurements, the light source produced by chemical reactions - namely emitted by chemiluminescence or fluorescence - the emitting surface 11 will be for example the free surface of a test-tube, or even the lateral surface through the thickness of the optically transparent wall of the test-tube, containing a liquid in which are present appropriate molecules in suspension able to react with the molecules to identify, producing a chemiluminescence reaction or through excitation energy produced by an appropriate fluorescent light beam.

The light is produced by activated molecules that are present on the surface, and the photons are emitted in all directions in a temporally random way: the measure of the amount of photons emitted during a predetermined time requires the reduction of the dispersion angle, with minimized losses, and the device regulating the light beam which is the object of the present invention is therefore applicable.

The system of measurement of the amount of light is manufactured though a photomultiplier detector with photocathode of large area, or a photodiode or avalanche photodiode, or other types of photoelectric detectors, placed at the output light source indicated by number 15: it should be pointed out that the frusto-cone 13 and 14 directing the light can also be developed in such a way as to transform the transversal section of the light beam for example from circular to rectangular, or vice versa, thus adapting the section of the beam emitted from the surface 11 to the shape of the surface of the photo detector; this particular type of measurement can optimize the optical efficiency as well as the cost of the measurement system.

By way of example a classic test-tube presents a circular free section with a diameter of about 10 mm, and a classic photomultiplier such as mod. RCA 1 P21 has a rectangular photocathode of 8x24 mm.

## Claims

1. Device for the regularization and optimization of the energy efficiency of light beams **characterized in that** it comprises at least one element having frusto-conical or pyramidal shape and having circular, elliptical or polygonal section in which the lateral surface can reflect the light beams incoming in said device towards the inside in order to reduce the angle of dispersion of said light beams.

2. Device according to claim 1 **characterized in that** the incident light beam input surface (12, 22) corresponds to the surface of the smaller base of said device and the output surface (15, 25) of said light beam corresponds to the surface of the larger base of said device.

3. Device according to claims 1 - 2 **characterized in that** it comprises a reflecting conic cavity.

4. Device according to claims 1 - 3 **characterized in that** the surface of said reflecting conic cavity comprises a sequence of conic surfaces (13, 14) having different opening angles with respect to the symmetry axis.

5. Device according to claims 1 - 4 **characterized in that** the surface of said reflecting conic cavity comprises a layer of reflecting coating.

6. Device according to claim 5 **characterized by** the fact that said layer of reflecting coating comprises a reflecting metallization.

7. Device according to claims 1 - 6 **characterized in that** it comprises a condenser (35) made of a bi-convex lens inserted at the light beam output.

8. Device according to claims 1 - 2 **characterized in that** it is made of optically transparent material.

9. Device according to claim 8 **characterized in that** the lateral surface of said device comprises a sequence of surfaces (23, 24) having different opening angles with respect to the symmetry axis.

10. Device according to claim 9 **characterized in that** said external lateral surface is made of polishable material.

11. Device according to the claim 9 **characterized in that** it comprises a reflecting coating on the external lateral surface.

12. Device according to claim 11 **characterized in that** said reflecting coating comprises a reflecting metallization.

13. Device according to claims 8-12 **characterized in that** the input surface (42) and output surface (44) of said light beam are made in a way to constitute an input concave lens and an output convex lens.
